# EUROPEAN PATENT APPLICATION

(11) **EP 0 700 096 A2**
(43) Date of publication of application: **06.03.1996**
(21) Application number: 95113790.0
(22) Date of filing: 01.09.1995
(51) Int. Cl.: H01L 29/78, H01L 29/786

(54) **SOI-field effect transistor und method for making the same**

(30) Priority: 01.09.1994 JP 232284/94
(71) Applicant: NEC CORPORATION, Tokyo (JP)
(72) Inventor: Yoshino, Akira, Minato-ku, Tokyo (JP)
(74) Representative: VOSSIUS & PARTNER

(57) **Abstract**

Disclosed is a SOI-type semiconductor device having a monocrystalline silicon substrate, an insulator thin-film formed on the substrate, a monocrystalline silicon thin-film formed on the insulator thin-film, and a gate electrode formed on the monocrystalline silicon thin-film with inserting a gate insulating film therebetween, wherein the semiconductor device forming a thin-film transistor by the monocrystalline silicon thin-film including source, drain and channel regions, and the gate electrode serving as a control electrode, characterized in that the insulator thin-film has an aperture just below the gate electrode, and the monocrystalline silicon substrate has a protrusion extending into the aperture. The method for making the SOI-type semiconductor device is also disclosed.

## Description

This invention relates to a SOI(Silicon on Insulator)-type semiconductor device, and more particularly to, a SOI-type semiconductor device in which silicon thin film of an active layer is epitaxially grown, and a method for making the same.

The integration density of a large-scale integrated circuit has rapidly been increased. Together with this, miniaturization of an element is rapidly proceeded, for example, the gate length of a MOS transistor in VLSI products has already become less than 0.5 micrometer and 0.05 micrometer in the research level. To realize submicron MOS transistors with high performance and long-term reliability, optimization in the structure should be carried out taking various factors into account.

Though the current drivability increases with a decrease in the gate length, "short channel effect" is also enhanced. The short channel effect includes such phenomena as a decrease in the threshold voltage and the source-drain breakdown voltage, and an increase in the subthreshold swing with a decrease in the gate length.

In general, to suppress the short channel effect, the impurity concentration in a channel region should be increased corresponding to a decrease in the gate length. However, if a MOS transistor is fabricated along the conventional design concept, the time required to charge bind discharge the parasitic capacitance is increased. This causes a decrease in the operating speed of the circuit, since the capacitance of the p-n junction formed between a drain and a substrate increases.

Recently, the substrate with a SOI structure (hereinafter referred to as 'SOI substrate') has attracted attention and been developed as it can reduce the drain parasitic capacitance of CMOS circuits. In general, the SOI substrate consists of a single crystal silicon substrate, an insulating film like Sio₂ and a single crystal silicon thin film, wherein the silicon thin-film is used as an active layer. Various methods of making the SOI substrate are known.

However, in the conventional SOI-type semiconductor device, there is a problem of crystalline defects in the thin silicon film on the insulator. Therefore, the properties of the MOS transistor formed on the SOI substrate may become worse than that of the MOS transistor formed on the silicon substrate.

Accordingly, it is an object of the invention to provide a SOI-type semiconductor device in which the properties of a transistor can be improved by placing an active area of the transistor in an area with much smaller density of the crystalline defect.

It is a further object of the invention to provide a thin-film transistor in which source-drain breakdown voltage can be improved.

It is a still further object of the invention to provide a SOI substrate in which defect in crystals can be reduced.

According to the invention, a SOI-type semiconductor device, comprises:
a monocrystalline silicon substrate;
an insulator thin-film formed on the substrate;
a monocrystalline silicon thin-film formed on the insulator thin-film; and
a gate electrode formed on the monocrystalline silicon thin-film with inserting a gate insulating film therebetween;
wherein the semiconductor device forming a thin-film transistor by the monocrystalline silicon thin-film including source, drain and channel regions, and the gate electrode serving as a control electrode, characterized in that:
the insulator thin-film has an aperture just below the gate electrode, and the monocrystalline silicon substrate has a protrusion extending into the aperture.

Furthermore, according to the invention, a method for making a SOI-type semiconductor device, comprises the steps of:
a) selectively etching a surface of a monocrystalline silicon substrate to form protrusions thereon;
b) depositing an insulating film on the entire surface then removing an unnecessary part of the insulating film to form an insulator thin-film filled between the protrusions;
c) epitaxially growing silicon while providing a monocrystalline surface of the protrusion as nuclei of growth to form a monocrystalline silicon thin-film on the protrusion and the insulator thin-film; and
d) forming a gate electrode on the monocrystalline silicon thin-film on the protrusion with inserting a gate insulating film therebetween to form a thin-film transistor which is provided with the gate electrode as a control electrode.

The invention will be explained in more detail in conjunction with the appended drawings, wherein:
FIGS. 1A to 1D are cross sectional views showing in turn steps of a conventional method for making a SOI-type semiconductor device,
FIG.2 is a cross sectional view showing a SOI-type semiconductor device in a first preferred embodiment according to the invention,
FIG.3 is a cross sectional view showing a SOI-type semiconductor device in a second preferred embodiment according to the invention,
FIG.4 is a cross sectional view showing a SOI-type semiconductor device in a third preferred embodiment according to the invention, and
FIGS. 5A to 6D are cross sectional views showing a method for making the SOI-type semiconductor device in the first preferred embodiment according to the invention.

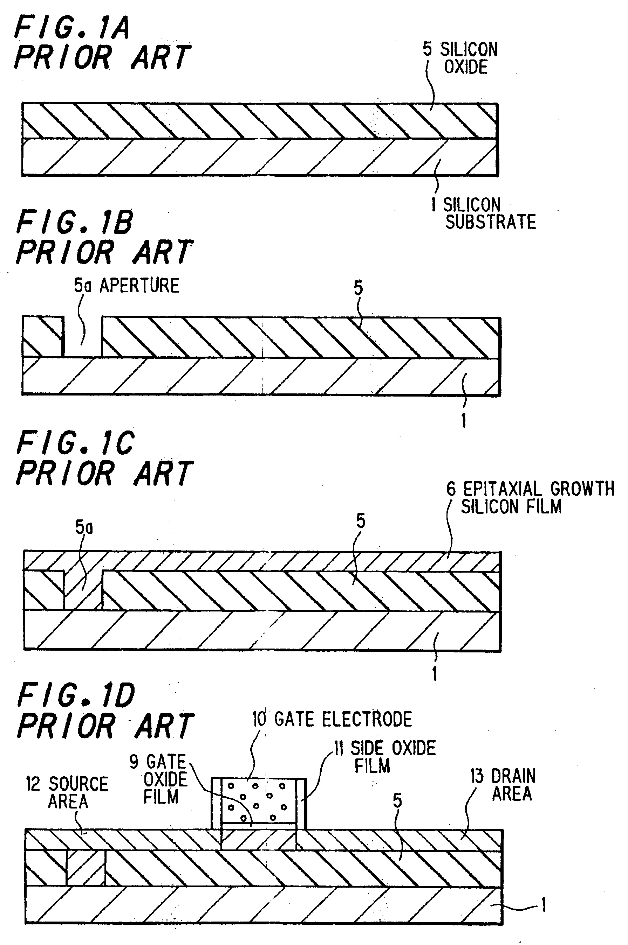

Before explaining a SOI-type semiconductor device in the preferred embodiment, the aforementioned conventional SOI semiconductor device and method for making the same will be explained in FIGS. 1A to 1D.

FIGS.1A to 1D are crops sectional views showing the conventional method for making a SOI substrate and a thin-film transistor (a MOS transistor) formed by employing the SOI substrate.

In the conventional method, at first, silicon dioxide thin-film 5 with a thickness of about 500 nm is deposited as an insulating layer on a monocrystalline silicon substrate 1 by CVD(Chemical Vapor Deposition) method or the like (FIG.1A).

Next, a part of the silicon dioxide film 5 is selectively removed to form an aperture 5a with desired dimensions by an usual photolithography and dry-etching technique, so that the surface of the monocrystalline silicon substrate 1 is partially exposed (FIG.1B).

Then an epitaxial growth silicon film 6 which has a thickness of about 100 to 500 nm is formed thereon by using the crystals on the surface of the silicon substrate 1 which is exposed through the aperture 5a as a seed of the epitaxial growth (FIG.1C).

Thereafter, by an usual processing technique, a gate electrode 10 is formed on the silicon film 6 and a side wall oxide film 11 is formed on the side thereof. Then a source area 12 and drain area 13 are formed on the silicon film 6 by introducing an impurity element of arsenic, boron or the like while using the gate electrode 10 and side wall oxide film 11 as a mask (FIG.1D).

In the above conventional method for making a SOI substrate, since the epitaxial growth silicon film 6 is always in contact with the side wall of the aperture 5a at the stage that it grows to fill the aperture 5a further being in contact with the surface of the silicon oxide film 5 at the stage that it grows to spread over the surface thereof, many crystalline defects in crystals are created near the interface of the epitaxial growth silicon film and oxide film.

Therefore, the properties of the MOS transistor formed on the silicon film become worse than those of the MOS transistor formed on the silicon substrate. Moreover, in the former MOS transistor, since the quality of the silicon film 6 degrades with an increase in the distance from the aperture 5a, the properties thereof become worse corresponding to it.

On the other hand, as shown in FIG.1D, the channel region of the conventional MOS transistor is separated from the other area, whereby, for example, when the MOS transistor is n-channel type, holes generated by the impact ionization phenomenon at the drain end are stored in the channel region. Therefore, a forward bias can be occurred between the channel region and the source, and parasitic bipolar action occurs, thereby the effective source-to-drain breakdown voltage thereof decreases.

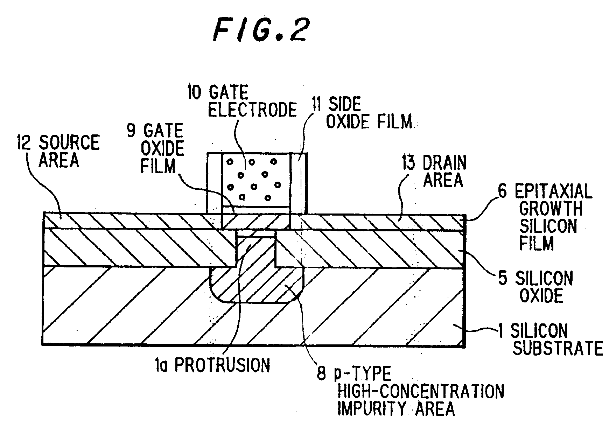

Now, a SOI-type semiconductor device in the first preferred embodiment of the invention will be explained in FIG.2, wherein like parts are indicated by like reference numerals as used in FIG.1A to 1D.

As shown in FIG.2, a silicon dioxide film 5 is formed on the (100) surface of a P-type monocrystalline silicon substrate 1. The monocrystalline silicon substrate 1 has a protrusion 1a, and the exposed surface of the protrusion 1a forms a flat surface together with the upper surface of the silicon dioxide film 5 with a thickness of about 500nm.

On the silicon dioxide film 5, an epitaxial growth silicon film 6 with a thickness of about 50 nm is formed by using the crystals on the surface of the protrusion 1a as a seed of the epitaxial growth. Furthermore, on the silicon film 6 formed on the protrusion 1a, a gate electrode 10 is formed with providing a gate oxide film 9 therebetween. In this embodiment, the gate length of the gate electrode 10 is a little longer than the width of the protrusion 1a. A sidewall oxide film 11 is formed on the side of the gate electrode 10. In the silicon film 6 on both sides of the gate electrode 10, a n⁺source area 12 and n⁺drain area 13 which have a LDD (Lightly Doped Drain) structure are formed.

Under the protrusion 1a and around the lower part thereof, a p-type high-concentration impurity area is formed by selectively doping p-type impurity. Because of this structure, the spreading of a depletion layer can be reduced and short channel effects can be suppressed. Since the high-concentration impurity area 8 is formed such that it does not contact with the source and drain areas 12, 13, the junction capacitance does not increase by forming the high-concentration impurity area does not occur.

In this SOI substrate, crystal growth begins from the protrusion 1a of the monocrystalline silicon 1. Thereby, an excellent epitaxial layer can be obtained in the vicinity of the channel region.

The quality of crystals in the epitaxial growth silicon film 6 degrades with an increase in the distance from the protrusion 1a. However, in the semiconductor device according to the invention, the active area of the transistor is just placed on the protrusion where the crystalline quality is excellent, thereby providing the transistor with good properties.

On the other hand, since the channel region is connected to the silicon substrate, holes generated by the impact ionization can flow to the substrate. Therefore, parasitic bipolar action does not occur and the source-to-drain breakdown voltage is improved.

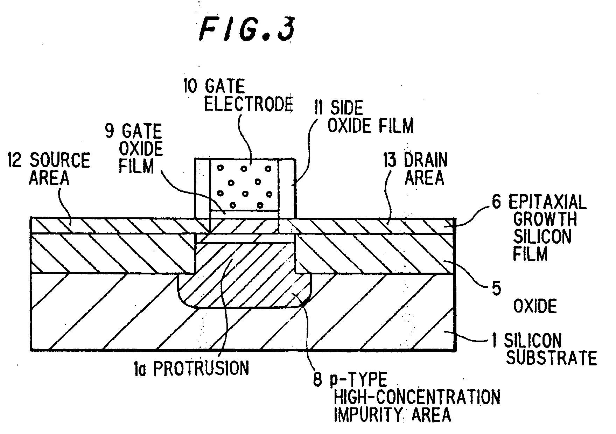

With reference to FIG.3 which shows the second preferred embodiment and wherein like parts are indicated by like reference numerals as used in FIG.2, disclosed is an example in which the width of a protrusion 1a is larger than the distance between a source junction and a drain junction. As a result, the leakage current of the p-n junction can be reduced dramatically since the quality of the crystal in the vicinity of the p-n junction is much higher than that in the first embodiment.

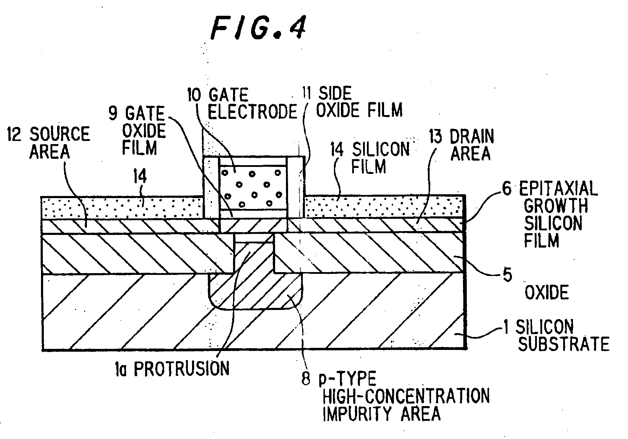

With reference to FIG.4 which shows the third preferred embodiment and wherein like parts are indicated by like reference numerals as used in FIG.2, there is provided an example in which a silicon film 14 with a thickness of about 60 nm is selectively formed on the source and drain areas 12, 13 of n-channel MOS transistor in the first embodiment shown in FIG.2. By the formation of the silicon film 14, the parasitic resistance of the source and drain region can be reduced since the thickness of the silicon films of the source and drain areas 12, 13 as shown in FIG.2 or 3 is substantially increased. Therefore, there is an advantage that the current drivability of the transistor is enhanced.

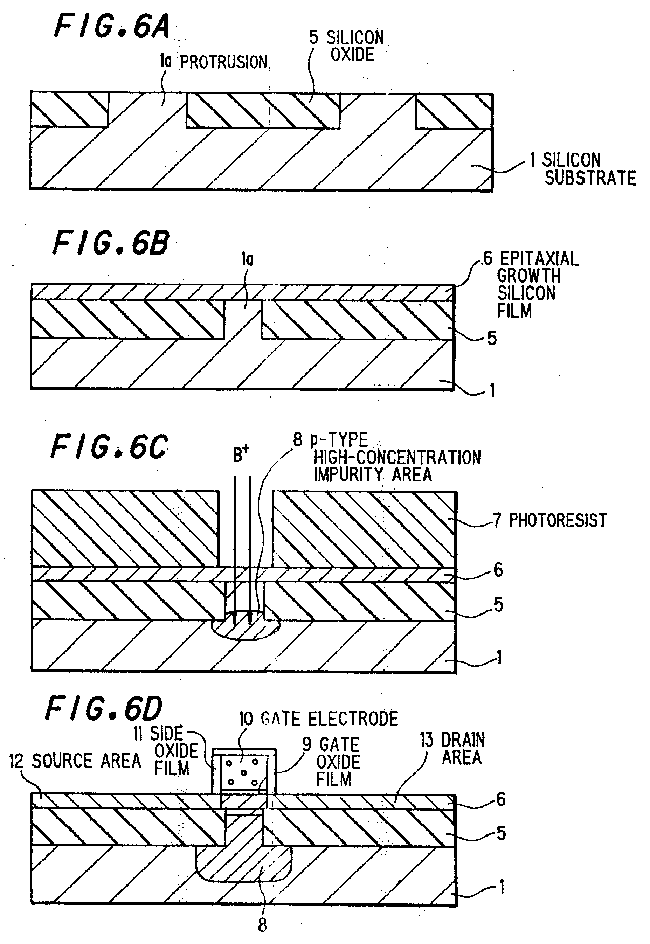

Now, with reference to FIGS.5A to 5D and 6A to 6D, the method for making the SOI-type semiconductor device in the first preferred embodiment will be explained below. FIGS. 5A to 5D and 6A to 6D show in turn the respective steps of the method thereof.

First, a silicon oxide film 2 with a thickness of about 40 nm is formed by thermal oxidation on a p-type monocrystalline (100) silicon substrate 1 which has a specific resistance of about 1 to 20 Ω·cm. Then polycrystalline silicon film 3 with a thickness of about 200 nm is formed on the silicon oxide film 2 by CVD technique (FIG.5A).

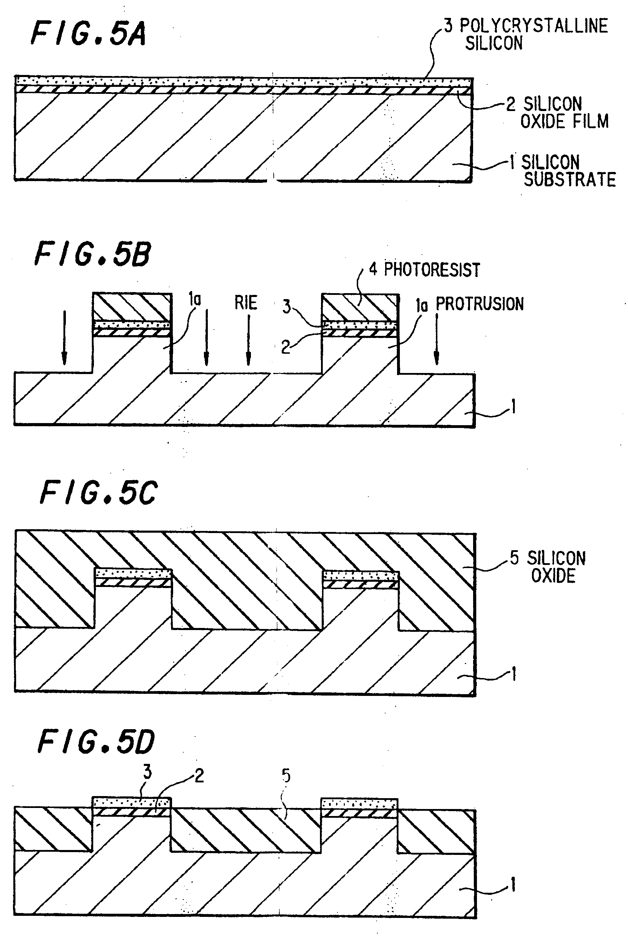

Next, by a conventional photolithography technique, the photoresist 4 is patterned thereon such that it covers only the part for using as a seed of the epitaxial silicon growth, i.e., the region for forming the protrusion 1a. Thereafter, using the reactive ion-etching method in which the photoresist 4 is used as a mask, the protrusions 1a with a height of about 500 nm are formed on the silicon substrate 1 (FIG. 5B).

After removing the photoresist 4, the silicon oxide film 5 with a thickness of about 100 nm is formed thereon by CVD technique. Hereon, it is preferable that, in order that a surface gap on the silicon oxide films which may be caused by the difference in channel width, i.e., wide and narrow channels coexist, can be reduced, a CVD oxide film is deposited to a thickness nearly equal to the height of the protrusion prior to the deposition of the silicon oxide film 5, and the CVD oxide film is left as a dummy pattern only between the protrusions 1a by photolithography technique (FIG.5C).

Thereafter, the silicon oxide film 5 is polished by using mechanical polishing technique, mechanical and chemical polishing technique or the like. Hereon, the polishing speed can be controlled, for example, by decreasing it just before the surface of the polycrystalline silicon film 3 is exposed as compared with the polishing speed until then, to precisely control the film thickness of the silicon oxide film 5 which is filled between the protrusion 1a (FIG.5D).

After removing the polycrystalline silicon film 3, the silicon oxide film 2 is then removed to expose the surface of the silicon substrate 1, i.e., the top surface of the protrusion 1a, by using a diluted solution of hydrofluoric acid. Hereon, the surface gap between the silicon substrate 1 and the silicon oxide film 5 can be significantly decreased by optimizing the process condition (FIG.6A).

The epitaxial growth silicon film 6 with a thickness of about 50 nm is then formed by growing silicon thereon while employing the crystalline surface of the silicon substrate 1 exposed as a seed of the epitaxial silicon growth (FIG.6B). In the step of epitaxial growth, if both surfaces of the protrusion 1a and the silicon oxide film 5 are processed such that they form a flat face, the crystal quality of the epitaxial growth silicon film 6 formed thereon can be more improved.

A photoresist 7 is then formed thereon with leaving an opening over the protrusion 1a by a conventional photolithography technique. Using it as a mask, boron ions, B+, are implanted at the acceleration energy of about 200 keV to a dose of about 5x10¹² to 1x10¹³ cm⁻², so that a p-type high-concentration impurity area 8 is formed at the desired position below the gate electrode, i.e., at the protrusion 1a. Further, the implantation of boron ions is performed at the acceleration energy of about 15 keV to a dose of about 1x10¹² cm⁻¹² (FIG. 6C) to control the threshold of the transistor.

Alternately, the high-concentration p-type region 8 can be formed by implanting ions in the stage of FIG.5A or introducing an impurity into the surface of the substrate before then. Also, it may be formed in the stage of FIG.5D or 6A. The impurity concentration in the high-concentration p-type 8 is preferably 1x10¹⁷ cm⁻³ or more to suppress the short channel effect.

The gate oxide film 9 is then formed thereon by thermal oxidation, followed by the deposition of the phosphorus-doped polycrystalline silicon film thereon and it is patterned to form the gate electrode 10. Ions of such n-type impurity element as arsenic or the like are implanted thereto, further forming the sidewall oxide film 11, and again implanting n-type ions to form the source and drain areas 12, 13 with LDD structure (FIG. 6D).

Alternately, in the stage of forming the gate electrode, the photomask used in patterning the photoresist 4 shown in FIG 5B may be diverted to pattern the photoresist for forming the gate electrode when the width of the protrusion 1a is set equal to the gate width.

The above method for making the SOI-type semiconductor device can similarly be used in making the device in the second and third embodiments.

Though the above method relates to the n-channel type thin-film transistor, a p-channel type transistor can similarly be formed by only changing tee conduction type of the impurity. Also, CMOS circuit 5 can easily be realized by that p-well and n-well are formed on the silicon substrate 1 before the stage of FIG.5A and n- or p-channel thin-film transistor is formed on the respective wells. Hereon, the contacts for fixing the potential of the respective well can easily be realized by remaining the silicon oxide film 5 positioned at the contact hole and the following growth of the epitaxial silicon film 6.

Although the invention has been described with respect to specific embodiment for complete and clear disclosure, the appended claims are not to be thus limited but are to be construed as embodying all modification and alternative constructions that may be occurred to one skilled in the art which fairly fall within the basic teaching here is set forth.

## Claims

1. A SOI-type semiconductor device, comprising:
a monocrystalline silicon substrate;
an insulator thin-film formed on said substrate;
a monocrystalline silicon thin-film formed on said insulator thin-film; and
a gate electrode formed on said monocrystalline silicon thin-film with inserting a gate insulating film therebetween;
wherein said semiconductor device forming a thin-film transistor by said monocrystalline silicon thin-film including source, drain and channel regions, and said gate electrode serving as a control electrode, characterized in that:
said insulator thin-film has an aperture just below said gate electrode, and said monocrystalline silicon substrate has a protrusion extending into said aperture.

2. A SOI-type semiconductor device according to claim 1, wherein:
said protrusion of said monocrystalline silicon substrate has a dimension in plane which is nearly equal to that of said gate electrode or slightly longer in the direction of the gate length than that of said gate electrode.

3. A SOI-type semiconductor device, according to claim 1 or 2, wherein
said protrusion of said monocrystalline silicon substrate is implanted with an impurity whose concentration is higher than that of impurity in said channel region.

4. A SOI-type semiconductor device, according to claim 1, 2 or 3,
further comprising a silicon thin-film formed on said source and drain areas in said monocrystalline silicon thin-film.

5. A method for making a SOI-type semiconductor device, comprising the steps of:
a) selectively etching a surface of a monocrystalline silicon substrate to form protrusions thereon;
b) depositing an insulating film on the entire surface then removing an unnecessary part of said insulating film to form an insulator thin-film filled between said protrusions;
c) epitaxially growing silicon while providing a monocrystalline surface of said protrusion as nuclei of growth to form a monocrystalline silicon thin-film on said protrusion and said insulator thin-film; and
d) forming a gate electrode on said monocrystalline silicon thin-film on said protrusion with inserting a gate insulating film therebetween to form a thin-film transistor which is provided with said gate electrode as a control electrode.

6. A method for making a SOI-type semiconductor device, according to claim 5, further comprising the step of doping an impurity to a surface of said silicon substrate prior to the step a) or b), whereby said protrusion forms a high-concentration impurity area.

7. A method for making a SOI-type semiconductor device, according to claim 5, further comprising the step of implanting impurity ions to said protrusion beyond said monocrystalline silicon thin-film after the step c) and prior to the step d), whereby the impurity concentration in said protrusion is higher than that in a channel region in said monocrystalline thin-film.
